# EUROPEAN PATENT APPLICATION

(11) **EP 1 744 347 A1**
(43) Date of publication of application: **17.01.2007**
(21) Application number: 05255242.9
(22) Date of filing: 25.08.2005
(51) Int. Cl.: H01J 37/34, C23C 14/34

(54) **Enhanced magnetron sputtering target**

(30) Priority: 11.07.2005 US 177555
(71) Applicant: Heraeus, Inc., Chandler, AZ 85226 (US)
(72) Inventor: Cheng, Yuanda R, Phoenix, AZ 85048 (US); Kennedy, Steven Roger, Chandler, AZ 85226 (US); Yang, Xingbo, Phoenix, AZ 85048 (US)
(74) Representative: Hill, Justin John

(57) **Abstract**

An enhanced sputtering target is provided for use in a magnetron sputtering system. The sputtering target includes an active surface from which target material is sputtered and a back surface opposite the active surface. At least one magnet is embedded in the back surface of the target and is oriented to increase the magnetic field passing through the active surface of the target.

## Description

### Field of the Invention

The invention concerns sputtering targets and in particular concerns sputtering targets enhanced for improved performance in magnetron sputtering systems.

### Background of the Invention

Diode sputtering systems are used to apply a film of target material to the surface of a substrate. An electric field is applied between a target and the substrate to generate a plasma within a sputter chamber. Ions from the plasma collide with the target and dislodge atoms of the target material. The dislodged atoms adhere to the surface of the substrate forming a film thereon.

Magnetron sputtering systems improve the sputter rates of diode sputtering systems by using a magnetic field in addition to the electric field. Magnetron sputtering systems arrange a magnetic array behind the sputter target to generate a magnetic field over the active surface of the target. The magnetie field traps ions in the plasma near the active surface of the target, thereby increasing the plasma density and improving the sputter rate. However, the benefits provided by magnetron sputtering systems are reduced or lost when sputtering ferromagnetic target materials.

The deposition of magnetic materials such as ferromagnetic cobalt and nickel alloys is used in applications such as magnetic data storage. The high magnetic permeability and low pass-through flux characteristics of these materials make sputtering in a magnetron sputtering system difficult. Specifically, most or all of the magnetic field generated by the magnetic array of the magnetron sputtering system is shunted through the interior of the target rather than out through and over the active surface of the target.

Attempts have been made by target manufacturers to address the sputtering difficulties associated with ferromagnetic target materials. For example, strain has been induced in targets via hot or cold working of the material in efforts to raise the pass-through flux and lower the magnetic permeability of the target material. However, the ability to improve these characteristics is limited. Alternative solutions have included modifying the settings or configurations of magnetron sputtering systems to increase the magnetic field generated. These solutions are also not ideal.

Accordingly, a need exists for an improved magnetron sputtering target that improves sputtering efficiency of ferromagnetic materials without requiring extensive modification to existing magnetron sputtering systems.

### Summary of the Invention

The present invention addresses the foregoing deficiencies of conventional sputtering targets by embedding magnets in the sputtering target. Specifically, one or more magnets are embedded in a back surface of the sputtering target and are oriented to increase the magnetic field passing through the sputtering target into the sputter chamber. By increasing the magnetic field in the sputter chamber, plasma density is increased which improves sputter rates and operating voltages can be reduced.

According to one aspect of the invention, a sputtering target is provided for use in a magnetron sputtering system. The sputtering target includes an active surface from which target material is sputtered and a back surface opposite the active surface. At least one magnet is embedded in the back surface of the sputtering target. The magnet is further oriented to increase the magnetic field passing through the active surface of the target. The sputtering target typically comprises ferromagnetic materials, however, non-ferromagnetic materials may be used as well.

Preferably, the embedded magnet is a rare earth magnet and is aligned within the center of a sputter track of the magnetron sputtering system. In addition, the magnet is preferably embedded in the target at a depth from the active surface greater than the maximum depth of the sputter track.

The enhanced sputtering target may also include a backing plate bonded to the back surface of the target. Magnets may be embedded in the backing plate, the target material or both.

The foregoing summary of the invention has been provided so that the nature of the invention can be understood quickly. A more detailed and complete understanding of the preferred embodiments of the invention can be obtained by reference to the following detailed description of the invention together with the associated drawings.

### Brief Description of the Drawings

Figure 1 is a diagram depicting components of a magnetron sputtering system.

Figure 2A is a diagram depicting a cross-section of a conventional sputtering target.

Figure 2B is a diagram depicting a cross-section of a sputtering target configured according to one embodiment of the present invention.

Figure 3A is a diagram depicting a cross-section of a conventional sputtering target having a backing plate.

Figure 3B is a diagram depicting a cross-section of a sputtering target having a backing plate according to one embodiment of the present invention.

### Detailed Description of the Invention

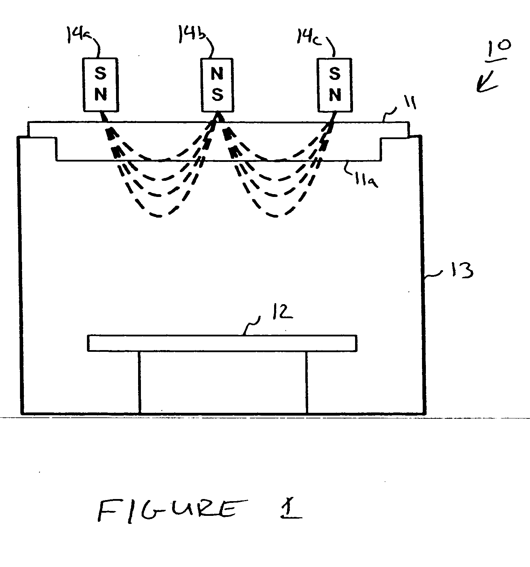

Figure 1 is a diagram depicting components of magnetron sputtering system 10. Magnetron sputtering system 10 includes sputtering target 11 from which target material is sputtered onto the surface of substrate 12. During operation of the system, substrate 12 is placed in a sputter chamber formed by enclosure 13 and sputtering target 11. Magnetron sputtering system 10 further includes a magnetic array, which is depicted in Figure 1 as magnets 14a to 14c, for generating a magnetic field over active surface 11a of sputtering target 11. It is noted that this depiction of magnetron sputtering system 10 is only one example of a magnetron sputtering system and does not include all of the components used in the operation of the system. One skilled in the art will recognize the applicability of the present invention to magnetron sputtering systems having configurations that differ from that shown in Figure 1.

To sputter the target material from sputtering target 11, the sputter chamber is filled with a working gas such as Argon and an electric field is applied between sputtering target 11 and substrate 12. The electric field breaks down the working gas to generate a plasma in the sputter chamber. Ions in the plasma are attracted to and collide with active surface 11 a of sputtering target 11. These collisions dislodge atoms of the target material which then travel and adhere to the surface of substrate 12 to form a film thereon.

Magnetron sputtering system 10 uses a magnetic array, depicted as magnets 14a to 14c in Figure 1, to improve the sputtering process. The magnetic array generates a magnetic field, which is depicted with dashed lines in Figure 1. As shown in Figure 1, the magnetic field penetrates sputtering target 11 into the sputter chamber. The magnetic field increases the plasma density near active surface 11 a by trapping ions in the plasma. The increased plasma density improves the sputter rate of the system and allows the system to operate at lower voltages. Magnets 14a to 14c are intended to represent any of a number of magnetic arrays used in magnetron sputtering systems. The magnetic array may be implemented using electromagnets or permanent magnets of various shapes, sizes and/or configurations known to those skilled in the art.

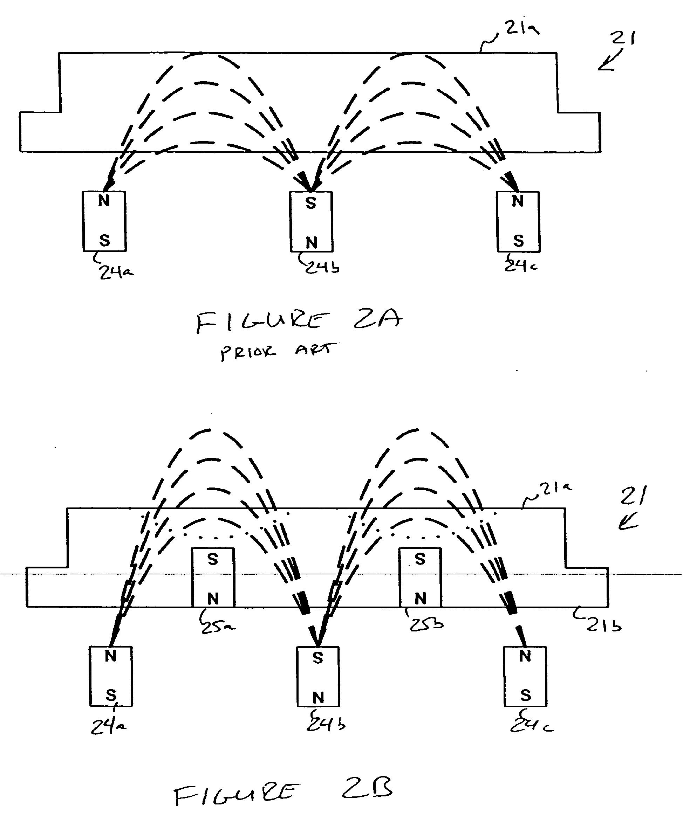

The penetration of the magnetic field through sputtering target 11 shown in Figure 1 represents a preferred mode of operation of magnetron sputtering system 10. As indicated above, however, the penetration of the magnetic field is reduced when sputtering ferromagnetic material in conventional systems. This reduction in penetration is caused by the high magnetic permeability and low pass-through flux characteristics typical to ferromagnetic materials. Figure 2A is a diagram depicting a cross-section of a conventional ferromagnetic sputtering target 21 and a magnetic array of a magnetron sputtering system, represented by magnets 24a to 24c. Ferromagnetic materials typically have high magnetic permeability and low pass-through flux properties. Accordingly, when magnets 24a to 24c generate a magnetic field, depicted as dashed lines, the magnetic field is shunted through the interior of sputtering target 21 rather than penetrating active surface 21 a into the sputter chamber. When the magnetic field does not penetrate into the sputter chamber, the advantages of a magnetron sputtering system are mostly lost and the system operates similar to a conventional diode sputtering system.

Figure 2B is a diagram depicting a cross-section of a ferromagnetic sputtering target 21 according to one embodiment of the invention. Similar to the configuration depicted in Figure 2A, a magnetic array of a magnetron sputtering system, represented by magnets 24a to 24c, is located near back surface 21b of sputtering target 21. To block the shunting of the magnetic field generated by magnets 24a to 24c, however, magnets 25a and 25b are embedded in back surface 21b. Magnets 25a and 25b may be implemented using any of a number of magnetic materials. For example, magnets 25a and 25b may be implemented using rare earth magnets made of Samarium Cobalt or Neodymium Iron Boride. One skilled in the art will recognize other magnetic materials and magnetic sources that may be used without departing from the scope of the present invention.

Magnets 25a and 25b are oriented within sputtering target 21 to block the shunting of magnetic field through the interior of the target and increase the amount of magnetic field penetrating active surface 21a into the sputter chamber. To achieve the results, one embodiment of the invention orients the magnetic poles of magnets 25a and 25b with those of the magnetic array represented by magnets 24a to 24c. Specifically, the magnetic poles of 25a and 25b are oriented parallel to those of the magnetic array. It is to be understood that this orientation represents one embodiment of the invention, and that alternative orientations that increase the magnetic field penetrating sputtering target 21 fall within the scope of the invention.

The shape and configuration of the embedded magnets are dependent on the configuration of the magnetic array in the magnetron sputtering system used for sputtering the target material. The configuration of the magnetic array defines the location of one or more sputter tracks in active surface 21 a. A sputter track represents an erosion pattern formed in active surface 21 a as the target material is sputtered. Representative sputter tracks are shown in Figure 2B with dotted lines. According to one embodiment of the invention, magnets 25a and 25b are aligned within the width of the sputter track and preferably are aligned with the center of the sputter track. In the configuration depicted in Figure 2B, aligning magnets 25a and 25b with the center of the sputter track places these magnets midway between respective pairs of magnets 24a to 24c. It is to be understood that the configuration of magnets 25a, 25b and 24a to 24c depicted in Figure 2B is a simple example that is intended to represent many different magnetic array configurations used in magnetron sputtering systems. The present invention is not intended to be limited to the configuration depicted in Figure 2B. Alternative configurations may utilize a single embedded magnet having an appropriate shape or multiple magnets having various shapes depending the magnetron design. One skilled in the art will recognize alternative shapes and configurations of the embedded magnets within the scope of the present invention that vary based on specific magnetron designs.

One advantage of embedding magnets 25a and 25b in sputtering target 21, rather than simply placing them externally on back surface 21b, is to place the magnets 25a and 25b closer to active surface 21 a. This increases the amount of magnetic field penetrating active surface 21 a into the sputter chamber, thereby improving the sputtering process. According to one embodiment of the invention, magnets 25a and 25b are embedded at a depth from active surface 21 a just below the maximum depth of the sputter track. This allows the magnets to be close to active surface 21 a, while preventing contamination caused by sputtering the magnets themselves.

Magnets 25a and 25b are embedded in back surface 21b using any of a number of methods known to those skilled in the art. For example, conventional machining techniques may be used to bore holes for each of the magnets. The magnets may then either be pressure fitted into the holes, bonded using known bonding techniques or a combination of these methods.

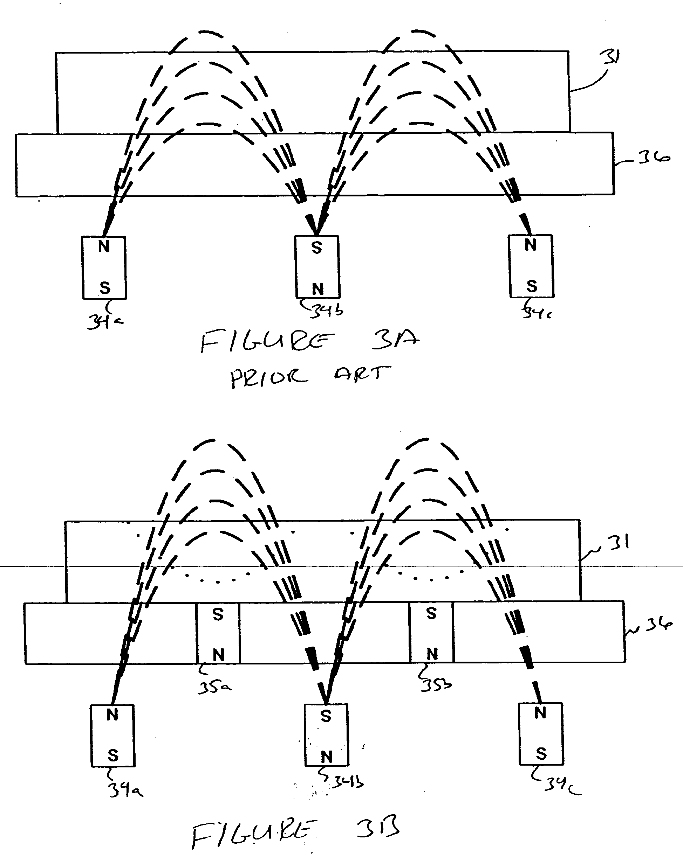

Figures 2A and 2B depict a monolithic target structure, which is directly mounted onto a sputter cathode in a magnetron sputtering system. Figures 3A and 3B depict a sputtering target having a two-part structure. Specifically, sputtering target 31 is bonded to backing plate 36, which is mounted on a sputter cathode during the sputtering process.

Similar to Figure 2A, Figure 3A depicts a cross-section of a conventional ferromagnetic sputtering target and a magnetic array of a magnetron sputtering system represented by magnets 34a to 34c. As shown in Figure 3A, the ferromagnetic material of the sputtering target causes the magnetic field, depicted as dashed lines, generated by the magnetic array to be shunted through the sputtering target. Accordingly, the improvements to the sputtering process provided by the magnetron sputtering system are reduced or lost.

Figure 3B depicts a cross-section of a ferromagnetic sputtering target according to one embodiment of the invention. As shown in Figure 3B, magnets 35a and 35b are embedded in backing plate 36. With the exception of being embedded in backing plate 36 rather than in target material, the orientation and configuration of magnets 35a and 35b with respect to the magnetic array and the sputtering target is the same as that for magnets 25a and 25b described above with respect to Figure 2B.

An advantage to embedding the magnets in the backing plate is that when the sputtering target has been consumed, the backing plate can be removed and bonded to a new sputtering target. Alternative embodiments of the two-part sputtering target include embedding magnets 35a and 35b in sputtering target 31 (similar to that shown in Figure 2B) at the interface with backing plate 36. Additionally, magnets 35a and 35b may be embedded completely or partially in both sputtering target 31 and backing plate 36.

As described above, the present invention provides a novel way to enhance sputtering targets for use in magnetron sputtering systems. A significant advantage provided by the invention is that the enhancements are made to the target itself rather than requiring extensive modifications to the magnetron sputtering system. The invention has been described in the context of sputtering targets made of ferromagnetic sputtering material. It is to be understood, however, that the invention is equally applicable to non-ferromagnetic sputtering targets to improve sputter rates. Furthermore, the invention is not limited to sputtering targets having specific shapes. For example, the sputtering targets may be circular, rectangular, etc.

The foregoing detailed description is intended to illustrate preferred embodiments of the invention. However, the examples set forth above are not intended to limit the scope of the invention, which should be interpreted using the claims set forth below. It is to be understood that various modifications to the illustrated examples of the invention can be made without departing from the spirit and scope of the invention.

## Claims

1. A sputtering target for use in a magnetron sputtering system, comprising:
a target having an active surface from which target material is sputtered and a back surface opposite the active surface; and
at least one magnet embedded in the back surface of said target and oriented to increase magnetic field passing through the active surface of said target.

2. The sputtering target according to Claim 1, wherein the target material is ferromagnetic.

3. The sputtering target according to Claim 1, wherein said at least one magnet is aligned with a sputter track of the magnetron sputtering system.

4. The sputtering target according to Claim 3, wherein said at least one magnet is aligned with the center of the sputter track.

5. The sputtering target according to Claim 1, wherein said at least one magnet is a rare earth magnet.

6. The sputtering target according to Claim 1, wherein said at least one magnet is embedded in said target at a depth from the active surface greater than the maximum depth of a sputter track on the active surface of said target.

7. The sputtering target according to Claim 1, further comprising a backing plate bonded to the back surface of said target.

8. The sputtering target according to Claim 1, wherein the magnetic pole of said at least one magnet is aligned in parallel with the magnetic pole of the magnetron sputtering system.

9. A sputtering target for use in a magnetron sputtering system, comprising:
a target having an active surface from which target material is sputtered and a back surface opposite the active surface;
a backing plate bonded to the back surface of said target; and
at least one magnet embedded in said backing plate and oriented to increase magnetic field passing through the active surface of said target.

10. The sputtering target according to Claim 9, wherein the target material is ferromagnetic.

11. The sputtering target according to Claim 9, wherein said at least one magnet is aligned with a sputter track of the magnetron sputtering system.

12. The sputtering system according to Claim 11, wherein said at least one magnet is aligned with the center of the sputter track.

13. The sputtering target according to Claim 9, wherein said at least one magnet is a rare earth magnet.

14. The sputtering target according to Claim 9, wherein the magnetic pole of said at least one magnet is aligned in parallel with the magnetic pole of the magnetron sputtering system.

15. The sputtering target according to Claim 9, wherein said at least one magnet is also embedded in the back surface of said target.

16. The sputtering target according to Claim 14, wherein said at least one magnet is embedded in said target at a depth from the active surface greater than the maximum depth of a sputter track on the active surface of said target.
